## Europäisches Patentamt
## European Patent Office
## Office européen des brevets

(19)

(11) Numéro de publication: **0 123 595**
**B1**

(12)

# FASCICULE DE BREVET EUROPEEN

(45) Date de publication du fascicule du brevet:
**05.08.87**

(51) Int. Cl.⁴: **H 05 K 7/14,** H 05 K 7/18

(21) Numéro de dépôt: **84400680.9**

(22) Date de dépôt: **06.04.84**

(54) **Dispositif entrée/sortie pour appareil du genre automate programmable, gamme de tels dispositifs et procédé pour réaliser leur bornier.**

(30) Priorité: **15.04.83 FR 8306175**

(43) Date de publication de la demande:
**31.10.84 Bulletin 84/44**

(45) Mention de la délivrance du brevet:
**05.08.87 Bulletin 87/32**

(84) Etats contractants désignés:
**BE DE FR GB IT NL SE**

(56) Documents cités:
**EP - A - 0 052 462**
**EP - A - 0 067 757**
**FR - A - 2 009 720**
**GB - A - 1 313 641**
**US - A - 3 609 462**
**US - A - 4 151 580**

(73) Titulaire: **LA TELEMECANIQUE ELECTRIQUE, 33 bis, avenue du Maréchal Joffre, F-92000 Nanterre (FR)**

(72) Inventeur: **Joly, Jean, 87 rue Condorcet, F-78800 Houilles (FR)**
Inventeur: **Oehlert, Yves, 44 rue A. Dufaure, F-92500 Rueil (FR)**
Inventeur: **Neyroud, Jean, Les Petiots Nurianette, F-38420 Domaines (FR)**
Inventeur: **Penot, Olivier, 60 avenue de Nice, F-06600 Antibes (FR)**
Inventeur: **Pergent, Jacky, 2 rue de Vésubie, F-06510 Carros (FR)**
Inventeur: **Barillier, Gilbert, Les Sausses, F-06510 Gattières (FR)**
Inventeur: **Le Blanc, Bernard, 1061 Route de la Mer, F-06410 Biot (FR)**

(74) Mandataire: **Bouju, André, Cabinet Bouju 38 avenue de la Grande Armée, F-75017 Paris (FR)**

ACTORUM AG

## Description

La présente invention concerne un dispositif d'entrée/sortie pour appareil de commande d'automatismes industriels, tel qu'un automate programmable, selon la première partie de la revendication 1, et comme connu du document US-A-4 151 580.

La présente invention concerne également une gamme de tels dispositifs.

La présente invention concerne encore un procédé pour réaliser un bornier pour de tels dispositifs.

Les automates programmables visés par l'invention comprennent dans leur réalisation pratique une unité centrale et des cartes présentant sur un bord des contacts intérieurs pour leur liaison à un BUS tel qu'un circuit imprimé lui-même en liaison avec l'unité centrale, et sur un autre bord des contacts extérieurs destinés à la liaison avec l'installation régie par l'automate. Les cartes entrée/sortie comportent des voies électroniques capables de transmettre et de traîter des signaux provenant de capteurs et destinés au BUS dans le cas des cartes d'entrée, et provenant du BUS et destinés à des actionneurs dans le cas des cartes de sortie. Du document EP-A-0 067 757 est connue une module électronique enfichable dans un connecteur de BUS.

Chaque carte, ci-après dénommée «carte entrée/sortie», fait partie d'un dispositif entrée/sortie comprenant encore un bornier ayant pour but d'associer à chaque contact extérieur de la carte une borne de branchement pour les conducteurs allant vers les capteurs ou respectivement les actionneurs.

Avec chaque dispositif d'entrée, on câble des circuits d'entrée comprenant chacun en série une source de tension, un interrupteur de capteur et une voie électronique de détection portée par la carte d'entrée. Avec chaque dispositif de sortie, on câble des circuits de sortie comprenant chacun en série un interrupteur porté par la carte, l'actionneur à commander et une source de tension.

Dans certaines applications, on souhaite que les circuits ainsi constitués soient isolés les uns des autres. Sur la carte, il est alors nécessaire que les différentes voies n'aient pas de point commun. Dans d'autres applications, il est commode d'utiliser une carte sur laquelle est prévue une liaison donnant un potentiel de référence commun a toutes les voies.

Ceci a cependant l'inconvénient que chaque type de carte entrée/sortie doit être fabriqué sous trois formes selon que les voies sont isolées, que le potentiel commun est positif ou que le potentiel commun est négatif. Malgré cela, la souplesse d'utilisation n'est pas exemplaire car à moins de varier encore les fabrications, on n'a pas la possibilité de rendre certaines voies isolées alors que d'autres portées par la même carte auraient un potentiel de référence commun. De plus, ces liaisons prévues sur la carte entre chaque voie et un point de potentiel commun sont gênantes car elles occupent une place précieuse sur la carte et nécessitent souvent des précautions spéciales pour leur faire croiser d'autres lignes conductrices de la carte.

Mais d'autres problèmes se posent lorsque les circuits entrée/sortie doivent être interconnectés. Il faut en effet encore prévoir entre les capteurs ou les actionneurs et la ou les source(s) électrique(s) un ou plusieurs borniers auxiliaires qui sont coûteux, encombrants et compliquent l'installation.

L'invention a pour but général de simplifier, et de rendre moins coûteux et plus commodes à monter, à câbler et à utiliser les dispositifs entrée/sortie des automates programmables ou appareils analogues pour la commande d'automatismes industriels. L'invention a en particulier pour but de diminuer le coût et l'encombrement liés aux interconnexions entre les circuits entrée/sortie dans les automates programmables ou analogues. L'invention vise ainsi un dispositif d'entrée/sortie connectable par un BUS à une unité centrale d'un appareil pour la commande d'automatismes industriels tel qu'un automate programmable, ce dispositif comportant au moins une carte supportant un certain nombre de voies électroniques de traitement et de transmission des signaux échangés entre le BUS et des appareillages comprenant des capteurs envoyant des signaux en entrée ou des actionneurs auxquels sont délivrés des signaux de commande en sortie, chaque carte étant connectée au BUS et à un bornier comprenant une série de bornes internes destinées à être branchées sur la carte et une série de bornes externes de liaison avec les appareillages, chaque voie électronique se trouvant en service incluse dans un circuit d'entrée/sortie en série avec une borne interne et une borne externe reliées électroniquement, le dispositif comprenant en outre des moyens pour interconnecter certains au moins des circuits d'entrée/sortie.

Suivant l'invention, le dispositif est caractérisé en ce qu'une partie au moins des moyens d'interconnexion est portée par le bornier.

On peut réaliser dans le bornier des interconnexions qui étaient auparavant réalisées sur certaines cartes. Il est alors possible de ne disposer que de cartes à voies isolées, et il n'est plus nécessaire d'avoir trois types différents pour chaque ensemble de fonctions données. Le coût de la fabrication et la valeur du stock minimal du fabricant (ou de l'utilisateur qui dispose de pièces de rechanges) peuvent être réduits de façon sensible car contrairement aux cartes, les borniers sont peu onéreux.

On peut également réaliser dans le bornier les interconnexions entre les appareillages (capteurs ou actionneurs) et la ou les sources électriques. Il n'est dès lors plus nécessaire de prévoir à cet effet des borniers auxiliaires qui jusqu'à présent grevaient les coûts et l'encombrement.

Selon un autre de ses aspects, l'invention vise encore une gamme de dispositifs entrée/sortie connectables par un BUS à une unité centrale d'un appareil pour la commande d'automatismes industriels tel qu'un automate programmable, cette gamme comprenant au moins un dispositif conforme au premier aspect de l'invention. Les dispositifs de la gamme comportent au moins une carte supportant un certain nombre de voies électroniques de traitement et de transmission des signaux échangés entre le BUS, et des appareillages comprenant des capteurs envoyant des signaux en entrée ou des actionneurs auxquels sont délivrés des signaux de commande en sortie. Chaque carte est connectée au BUS et à un bornier comprenant une série de bornes internes destinées à être branchées sur la carte, et une série de bornes externes de liaison avec les capteurs ou les actionneurs.

Suivant ce second aspect de l'invention, la gamme est caractérisée en ce que les borniers de tous les dispositifs de la gamme comprennent des carcasses isolantes sensiblement identiques et diffèrent par la conformation des liaisons électriques qui sont rapportées à leur intérieur entre les bornes externes et internes.

L'utilisateur peut ainsi choisir parmi les différents dispositifs de la gamme celui qui comporte le bornier renferment les liaisons électriques désirées entre les différentes bornes externes et internes. Les dispositifs de la gamme peuvent être variés sans que les coûts de fabrication soient fortement aggravés car il est peu onéreux de varier les schémas électriques dans des carcasses de bornier sensiblement identiques.

Selon un troisième aspect de l'invention, le procédé pour réaliser le bornier d'un dispositif conforme au premier aspect de l'invention ou faisant partie de la gamme du second aspect de l'invention, selon lequel on réalise une carcasse isolante dans laquelle on aménage une série de bornes internes adaptables à des contacts portés par la carte et une série de bornes externes pour la liaison avec des appareillages, et on relie entre elles les bornes internes et externes selon un schéma électrique déterminé, est caractérisé en ce que pour relier ainsi entre elles les bornes internes et externes, on réalise un ensemble de liaisons électriques dont certaines sont conformées pour relier entre elles directement et indépendamment des autres bornes une borne interne et une borne externe destinées à se correspondre, et d'autres sont conformées pour relier entre elles deux bornes de la même série au moins, et en ce qu'on réalise le schéma électrique voulu pour le bornier en montant dans la carcasse des liaisons choisies parmi l'ensemble précité.

Selon ce procédé la fabrication des différents borniers est encore simplifiée.

D'autres particularités et avantages de l'invention ressortiront encore de la description ci-après.

Aux dessins annexés, donnés à titre d'exemples non limitatifs:

– la figure 1 est une vue schématique partiellement en coupe d'un automate programmable;

– la figure 2 est un schéma électrique d'un demi-bornier d'entrée selon l'invention;

– la figure 3 est un schéma électrique d'un demi-bornier de sortie selon l'invention;

– la figure 4 est une vue du bornier et du boîtier en coupe partielle selon un plan transversal au bord de la carte associé au bornier;

– la figure 5 est une vue schématique en perspective des liaisons électriques dans le bornier;

– les figures 6 et 7 sont des vues en perspective des shunts entre bornes internes et externes respectivement;

– la figure 8 est une vue en perspective d'une liaison entre une borne externe et une borne interne;

– la figure 9 est une vue schématique en élévation latérale d'un dispositif entrée/sortie avec coupe du bac à automate et du circuit imprimé;

– la figure 10 est une vue en perspective éclatée montrant les guide-cartes et le boîtier en vue partielle, le bornier avec arrachement de son couvercle et différentes pièces de liaison dont une charnière à point dur qui est en coupe selon son plan de symétrie;

– les figures 11 et 12 sont des vues analogues à la partie droite de la figure 9, mais montrant l'une le bornier dégagé du boîtier, l'autre le bornier accroché au guide-carte en l'absence du boîtier;

– la figure 13 est une vue en perspective éclatée montrant le bornier, la charnière en coupe selon son plan de symétrie et en position de fermeture, le couvercle et le porte-étiquette;

– les figures 14 et 15 sont des vues schématiques en perspective du bornier en cours de câblage et respectivement en service; et

– la figure 16 est une vue analogue à la figure 2 mais concernant le bornier d'un autre dispositif de la gamme;

– les figures 17 et 18 sont des vues analogues aux figures 2 et 5 mais concernant le bornier d'un troisième dispositif de la gamme.

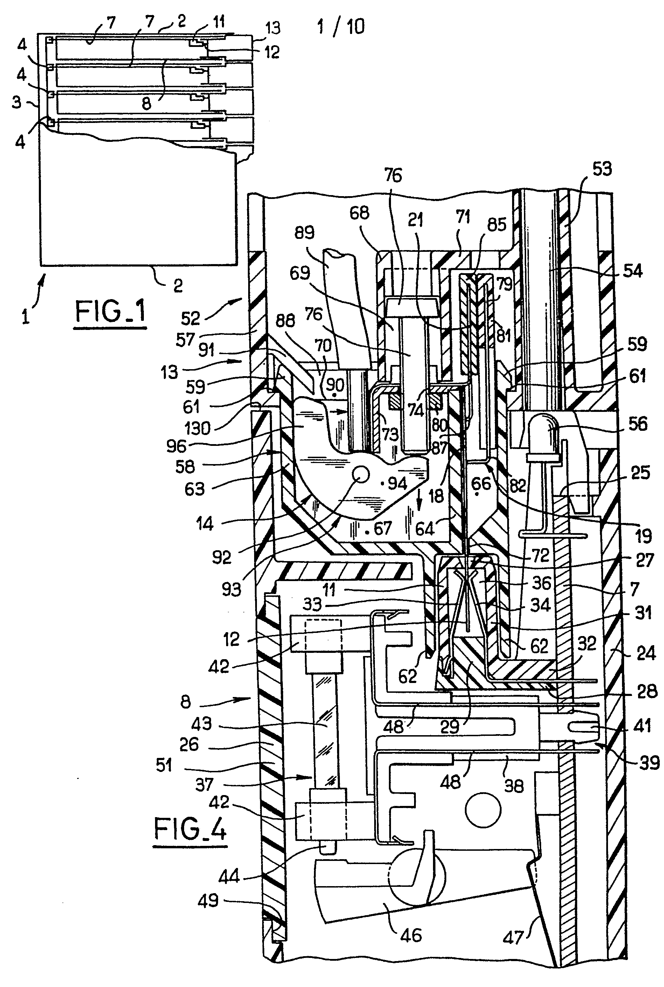

Comme le montre la figure 1, l'automate programmable, pris comme exemple d'appareil pour la commande d'automatismes industriels, comprend un bâti 1 comprenant à son tour des parois latérales 2 et un fond 3 dans lequel est logé un circuit imprimé portant des rangées de connexions 4 destinées à être reliées électriquement à des fiches aménagées le long de l'un des bords 6 d'une carte électronique telle que 7, montée dans un boîtier tel que 8. Les cartes peuvent être des cartes d'entrée 7 reliées à des capteurs, des cartes de sortie 7 reliées à des actionneurs, des cartes d'unité centrale (non représentées) ou encore des cartes d'alimentation (non représentées également). Une information provenant d'un capteur est traitée par une carte d'entrée et transmise par celle-ci au circuit imprimé qui, jouant le rôle de BUS, la transmet à l'unité centrale. En fonction des informations provenant des capteurs, l'unité centrale élabore des ordres qui sont dirigés vers les actionneurs via le BUS et une carte de sortie. Les cartes d'entrée/sortie 7, logées dans les boîtiers 8 font partie des dispositifs entrée/sortie qui sont plus particulièrement visés par l'invention. Chaque carte 7 porte au voisinage de son bord 9 opposé au bord 6 un connecteur 11 présentant une rangée de contacts destinés à coopérer avec les bornes internes 12 d'un bornier 13.

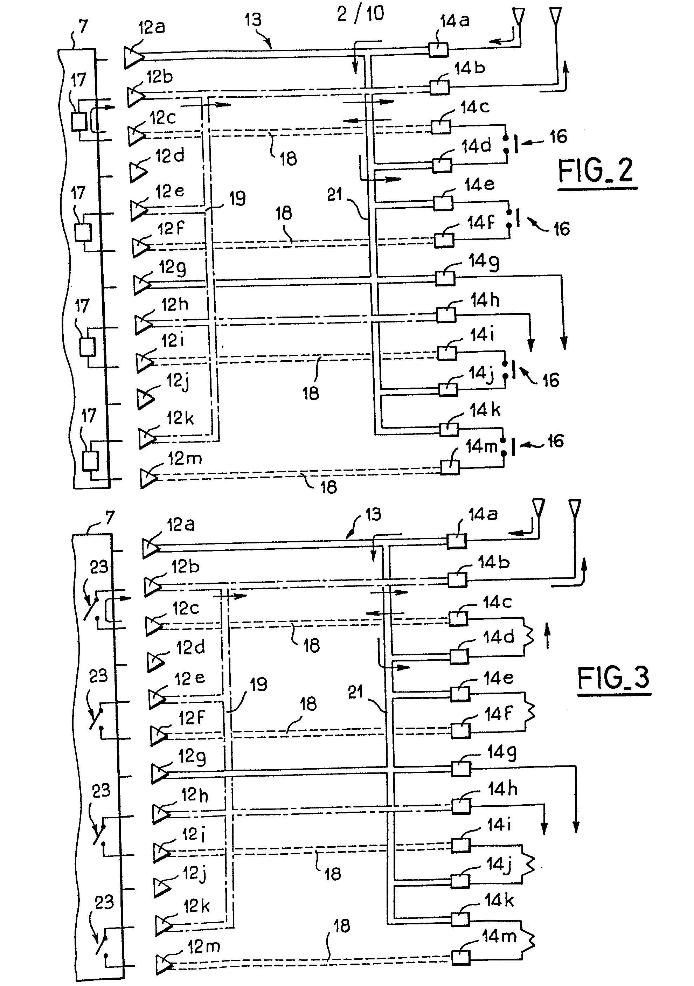

A la figure 2, les bornes internes du bornier 13 sont repérées 12a . . . 12m. Le bornier 13 présente en outre des bornes externes 14 repérées 14a ... 14m à la figure 2. Dans le cas d'une carte d'entrée, certaines au moins des bornes externes 14 relient le bornier 13 à des contacts 16 qui appartiennent à des capteurs (non représentés) dont l'ouverture ou la fermeture est indicative de l'état d'un appareil dont le fonctionnement est à surveiller.

Chaque contact 16 est associé à une voie électronique de détection 17 aménagée sur la carte 7.

Le bornier renferme en outre des liaisons électriques 18 reliant entre elles une borne interne (par exemple 12c) associée à l'une des extrémités d'une voie 17 et une borne externe (par exemple 14c) destinée à être branchée à l'une des bornes d'un contact 16 qui se trouvera ainsi associé à la voie 17 de la borne 12c.

Conformément à l'invention, les voies de détection 17 sont isolées les unes des autres. En outre, les deux extrémités de chaque voie 17 sont associées chacune à un contact externe de la carte destiné à être branché sur une borne interne 12 respective du bornier 13. En effet, chaque voie 17 est montée entre la première borne 12c, 12f, 12i ou 12m évoquée précédemment, et une seconde borne interne 12b, 12e, 12h, 12k. Les secondes bornes internes 12b, 12e, 12h, 12k sont reliées entre elles par un shunt 19 aménagé dans le bornier 13.

Le shunt 19 est réalisé sous la forme d'une liaison ramifiée également reliée à une borne externe d'alimentation 14b, destinée à être branchée à l'une des bornes d'une source électrique.

En outre, chaque contact 16 est monté entre la première borne externe 14c, 14f, 14i, 14m, déjà évoquée, et une seconde borne externe 14d, 14e, 14j, 14k. Les secondes bornes externes sont reliées entre elles par un shunt 21 aménagé dans le bornier 13. Le shunt 21 est réalisé sous la forme d'une liaison ramifiée également reliée à une autre borne d'alimentation 14a destinée à être branchée à l'autre borne de la source électrique précitée.

Grâce à la structure et aux branchements représentés, chaque capteur 16 est relié à une voie de détection 17 par un circuit d'entrée schématisé par des flèches à la figure 2, dans lequel on trouve en série la borne externe d'alimentation 14a, le shunt 21, une seconde borne externe (par exemple 14d), le capteur 16 associé à celle-ci, l'autre borne externe (14c) associée à ce capteur, une liaison 18, la première borne interne (12c) située en face, la voie 17 qui y est reliée, la seconde borne (12b) associée à cette voie, le shunt 19 et l'autre borne d'alimentation 14b.

Les shunts 19, 21 sont en outre reliés chacun à une borne externe de report d'alimentation 14h et respectivement 14g. Ces bornes permettent de reporter la tension de la source présente entre les shunts 19, 21 vers un autre bornier tel que 13.

Il est également possible que le schéma de la figure 2 ne soit que celui d'un demi-bornier aménagé sur le même support matériel qu'un autre demi-bornier identique ou similaire.

L'intérêt de cette disposition est de permettre de relier à une même carte des organes extérieurs tels que les contacts 16 fonctionnant sous des tensions différentes. Si tel n'est pas le cas, il suffit de relier par liaison externe les bornes 14g, 14h d'un premier demi-bornier aux bornes 14a, 14b d'un second demi-bornier, tandis que les bornes 14g, 14h du second demi-bornier pourront servir à reporter l'alimentation vers un autre bornier tel que 13.

Par ailleurs le shunt 21 est en cas de besoin relié à une borne interne 12a qui permet de disposer de la tension d'alimentation sur la carte entre la borne 12a et l'une des bornes internes reliées au shunt 19.

Comme le montre la figure 3, un bornier 13 exactement semblable à celui de la figure 2 peut être utilisé dans un dispositif de sortie, les actionneurs 22 étant montés entre les bornes externes entre lesquelles sont montés les contacts 16 à la figure 2, tandis que la carte de sortie 7 porte des voies de commande constituées par des interrupteurs 23 commandant le fonctionnement des actionneurs. Ces interrupteurs pouvant être électroniques sont branchés entre les contacts correspondant aux bornes internes 12 entre lesquelles sont montées des voies de détection 17 à la figure 2. Un circuit de sortie (flèches à la figure 3) est défini comme un circuit d'entrée excepté que le contact 16 est remplacé par un actionneur 22 et la voie 17 par la voie 23.

Le câblage est très simple puisque la source et les appareillages 16 ou 22 sont tous branchés sur le bornier 13 et il n'y a pas de liaisons à prévoir en dehors du bornier 13. Les borniers auxiliaires sont donc supprimés. De plus, conformément aux recommandations actuelles il n'y a qu'un fil à chaque borne.

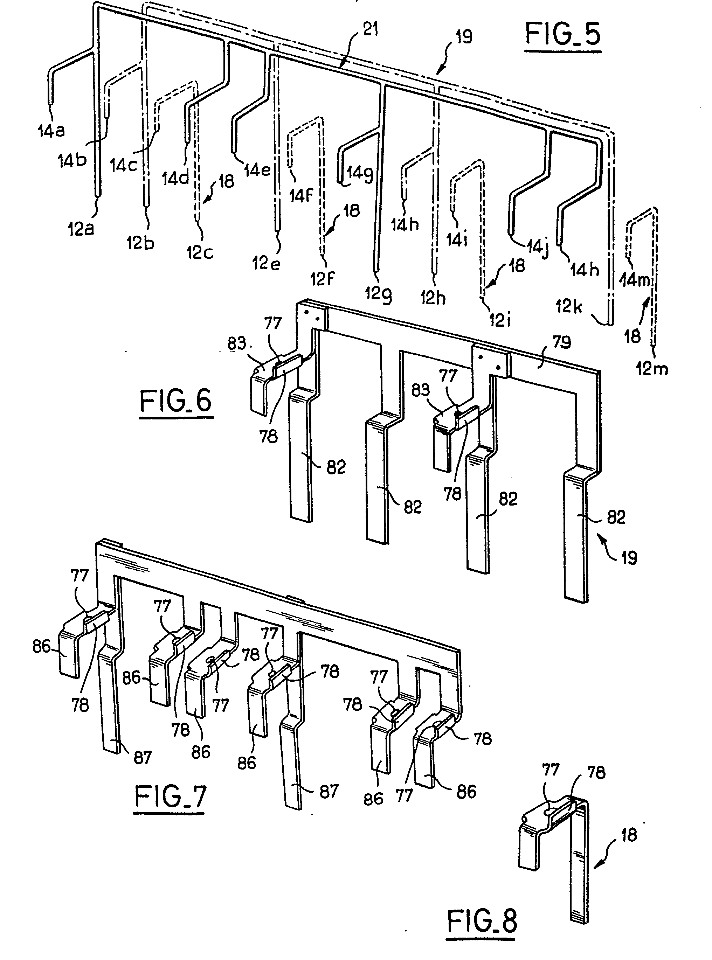

On va maintenant décrire en référence à la figure 4, le bornier 13 et la partie adjacente du boîtier 8, à l'intérieur duquel on reconnaît la carte entrée/sortie 7 qui est montée à faible distance de l'une des parois latérales 24 du boîtier, parallèlement à celle-ci.

La carte 7 porte du côté de l'autre paroi latérale 26 du boîtier le connecteur femelle 11 qui a un profil en L et s'étend parallèlement à la direction générale du bord 25 de la carte 7 tourné vers le bornier 13.

L'extrémité libre du profil en L est dirigée vers le bornier 13. Le connecteur femelle 11 présente dans cette extrémité libre une série d'ouvertures 27 réparties sur sa longueur, chacune destinée à recevoir un contact mâle 12 constituant l'une des bornes internes du bornier 13.

Chaque ouverture 27 et chaque borne interne 12 se trouvent ainsi dans un plan respectif – qu'on appellera ci-après plan élémentaire – qui est perpendiculaire à la direction générale du bord 25, c'est-à-dire parallèle au plan de la figure 4.

Le connecteur 11 comprend une embase 28 comportant à l'opposé de la carte 7 une nervure 29 sur laquelle est emboîté un capuchon 31 qui est traversé par les ouvertures 27. Le capuchon 31 est prolongé vers la carte 7 par une aile 32. Pour chaque plan élémentaire, deux lames de contact 33, 34 sont appuyées l'une contre l'autre, de façon à pouvoir y insérer un contact mâle 12, dans une cavité 36 comprise entre le capuchon 31 et la nervure 29. Les deux lames sont montées par coincement entre la nervure 29 et le capuchon 31. Chaque lame 34 se prolonge entre l'aile 32 et l'embase 28 pour être reliée électriquement à la carte 7.

Le boîtier 8 renferme encore, entre la carte 7 et la paroi 26, un bloc à fusibles 37 comprenant un corps 38 terminé du côté de la carte par des tenons 39 ayant une extrémité creuse, renflée et munie de fentes axiales 41 de façon à être encliquetable dans des passages correspondants que présente la carte 7 sous le connecteur 11.

Le corps 38 a la forme d'un T dont la jambe, perpendiculaire à la carte 7, a pour extrémité le tenon 39. Dans chaque plan élémentaire, les extrémités des bras du T portent une paire de douilles 42 se faisant face, entre lesquelles est monté un fusible amovible 43. Le percuteur 44 du fusible 43 est en face de l'une des extrémités d'un basculeur 46 dont l'autre extrémité coopère avec une lame de contact de signalisation de défaut 47 montée sur la carte 7. Chaque douille 42 est en contact électrique avec un conducteur coudé 48 s'étendant le long du corps 38 jusqu'à la carte 7 où il est branché de façon que le fusible 43 soit en série avec le contact externe 33, 34 situé dans le même plan élémentaire. Face aux blocs à fusibles 37, le boîtier 8 présente une ouverture 49 fermée en service par une trappe amovible 51. Les fusibles 43 peuvent être remplacés sur simple ouverture de la trappe 51.

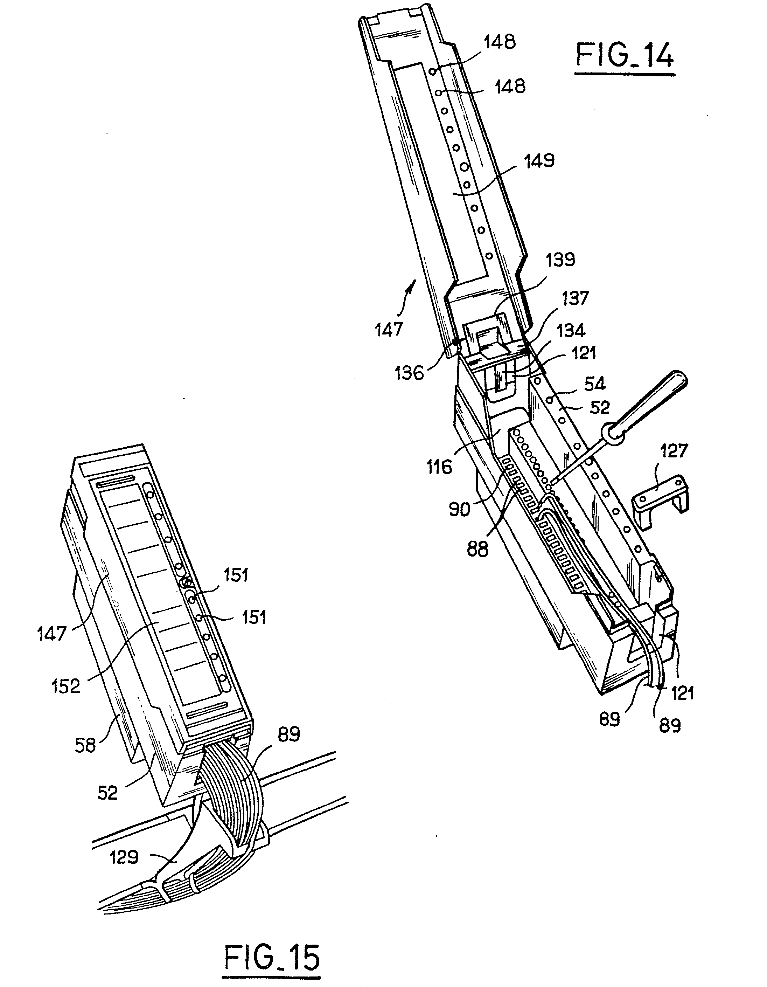

Le bornier 13 comprend un corps 52 comportant, sensiblement dans le prolongement de la carte 7, une paroi 53 dans laquelle est aménagé dans chaque plan élémentaire un conduit optique 54 dont l'extrémité dirigée vers le boîtier 8 est adjacente à une diode électroluminescente 56 fixée et branchée sur la carte 7 pour informer visuellement des conditions électriques au contact externe 33, 34 situé dans le même plan élémentaire. Comme le montre par exemple la figure 14, l'autre extrémité des conduits optiques 54 est dans un plan extérieur du corps de bornier 52.

Le corps 52 présente encore une paroi 57 (figure 4) qui en service est dans le prolongement de la paroi 51 du boîtier 8. Un élément en forme de chenal 58, qu'on appellera «fond de bornier» et qui constitue avec le corps 52 une carcasse isolante du bornier présente à chacun de ses bords longitudinaux libres des becs 59 dirigés vers l'extérieur et destinés à être encliquetés derrière des épaulements 61 que présentent à leur extrémité dirigée vers le boîtier 8 les faces dirigées l'une vers l'autre des parois 53 et 57. Le côté ouvert du fond 58 est dirigé vers le corps de bornier 52. Du côté opposé à cette ouverture, le fond 58 présente deux nervures 62 destinées à recevoir en emboîtement entre elles le capuchon 31 du connecteur femelle 11 tandis que l'une 63 des parois latérales du fond 58 est adjacente à la face interne de la paroi 51 du boîtier 8.

L'intérieur du fond 58 est subdivisé par une cloison longitudinale 64 en un compartiment 66 pour les liaisons électriques 18, 19, 21 d'un côté et de l'autre côté, une série de compartiments 67 — un par plan élémentaire — séparés par des cloisons 88 parallèles aux plans élémentaires. Chaque compartiment 67 est adjacent à la paroi 63 et contient l'une des bornes externes 14 du bornier 13. Une ouverture 90, définie du côté du corps 52 entre chaque paire de cloisons 88 voisines, sert à l'introduction d'un fil 89 reliant la borne 14 à l'appareillage à surveiller ou à commander 16, 22, ou à une source électrique.

Le corps de bornier 52 comporte de son côté une paroi épaisse 68 parallèle à la paroi 57 et dans laquelle est pratiqué dans chaque plan élémentaire un alvéole 69 s'ouvrant d'une part à l'opposé du boîtier 8 et d'autre part en face du compartiment à bornes externes 67. Une paroi 71 de liaison entre l'extrémité de la paroi épaisse 68 et la paroi 53 délimite du côté du boîtier 8 un espace qui communique avec le compartiment 66 et complète ce dernier.

Comme le montrent aussi les figures 5 à 8, les liaisons électriques 18 sont des lames métalliques pliées en forme de canne dont la jambe est appliquée contre la cloison 64 dans le compartiment 66 et fait saillie de ce dernier par une ouverture 72 prévue dans chaque plan élémentaire en face de l'ouverture correspondante 27 du capuchon 31. La partie recourbée de la canne est appliquée par sa face interne contre la partie centrale 70 d'un étrier conducteur dont les ailes 75 sont parallèles aux plans élémentaires et positionnées chacune contre l'une des deux cloisons 88 du compartiment 67 considéré. La partie centrale 70 est positionnée à l'extrémité de la cloison 64 de façon à s'étendre sous la paroi 68. A l'opposé de la cloison 64, la partie 70 est coudée en une patte 73 dirigée vers le boîtier 8 sensiblement dans le prolongement de la paroi 68. La partie 70 présente un perçage 74 dans lequel est engagée une vis de connexion 76 dont la tête est dans l'alvéole 69, et qui coopère avec un écrou 80 maintenu prisonnier de façon connue en soi entre les deux ailes 75 de l'étrier. Les liaisons 18, de même que les shunts 19 et 21 présentent des perçages correspondants 77 et à côté de ceux-ci des languettes 78 destinées à pénétrer dans l'alvéole 69 correspondant de façon à positionner les liaisons électriques 18, 19, 21 relativement au bornier 13.

Le shunt 19 (figure 6) comprend une lame découpée de façon à avoir une âme 79 s'étendant longitudinalement dans l'espace compris entre les parois 53, 71, 68 où elle est recouverte d'une gaine isolante 81 (figure 4), et des ailes 82 dont chacune est appuyée contre la cloison 64 et s'étend jusqu'au compartiment 36 en passant par le compartiment 66, une fente 72 et une fente 27. A l'âme 79, sont rivées deux pattes contre-coudées 83 (figure 6) profilées pour s'appliquer par leur face interne contre la partie 70 et la patte 73 de façon à constituer la liaison avec les bornes externes 14b et 14h (figures 2 et 3). Les pattes 83 portent les perçages 77 et languettes 78 évoquées plus haut.

Le shunt 21 (figure 7) comprend une lame découpée de façon à avoir une âme 84 analogue à l'âme 79 et logée en service dans une gaine 85 entre cette dernière et la paroi 68, et des ailes 86 conformées de façon analogue aux pattes 83 du shunt 19. En service, chaque aile 86 est appliquée par sa face interne contre la partie 70 et la patte 73 et y est traversée par une vis 76. A l'âme 84 sont rivées deux pattes 87 qui sont appuyées contre la cloison 18 et s'étendent jusque dans le compartiment 36 en passant par le compartiment 66, une ouverture 72 et une ouverture 27.

La figure 5 montre l'organisation relative pratique des trois types de liaisons (18, 19, 21) conformément au schéma électrique des figures 2 et 3.

La paroi 57 porte dans chaque plan élémentaire une lèvre 91 dirigée obliquement dans l'ouverture 90 à titre de rampe de guidage pour l'engagement du fil 89 d'une part, et de butée pour le bec d'encliquetage 59 d'autre part.

Chaque compartiment 67 contient un basculeur 93 auquel sont fixés deux tourillons opposés 92 montés en rotation chacun dans l'une des ailes d'étrier 75 qui, à cet effet, s'étendent au-delà de la patte 73 vers la paroi 63. Un bras 94 du basculeur 93 est dans la trajectoire de l'extrémité de la vis 76 tandis que l'autre bras 96 s'étend à peu près parallèlement à la vis 76 en direction opposée au boîtier 8, de façon qu'en enfonçant par vissage la vis 76 vers le boîtier 8, l'extrémité dénudée du fil 89 puisse être enserrée entre le bras 96 d'une part et le tronçon terminal, appuyé contre la patte 73, d'une liaison 18, d'une patte 83 ou d'une aile 86 d'autre part.

Pour le montage du bornier, on positionne l'étrier conducteur 70, 75, 73, les liaisons 18 et les shunts 19 et 21 relativement au fond de bornier 58 et on les y maintient en commençant le vissage des vis 76. On encliquette ensuite le fond 58 avec le corps 52 et on effectue les connexions aux bornes externes 14 en mettant en place les fils 89 et en serrant les vis 76, le mouvement de l'étrier 70, 75, 73 et des différentes liaisons électriques 18, 19, 21 en direction opposée au boîtier 8 étant empêché par appui contre la paroi épaisse 68. Il suffit ensuite d'emboîter le bornier 13 dans le boîtier 8 en même temps que l'on fait pénétrer selon une direction parallèle à celle de l'emboîtement précité l'extrémité libre des liaisons 18, des ailes 82 et des pattes 87 dans le connecteur femelle 11.

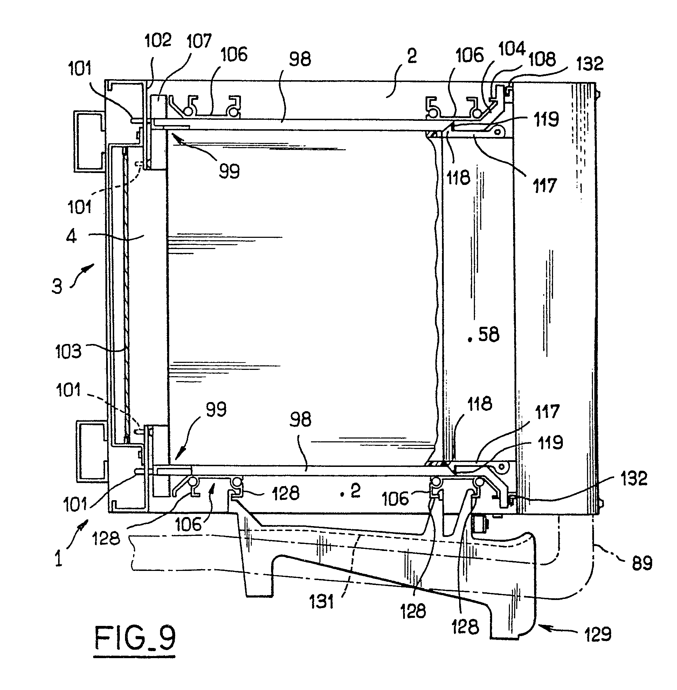

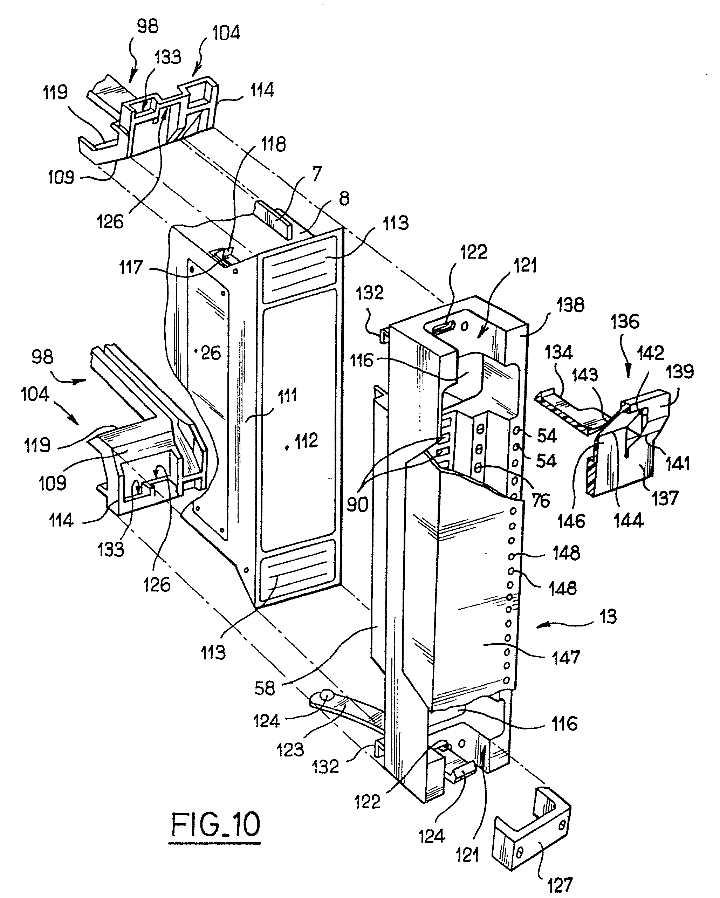

Comme le montre la figure 10, la carte 7 fait saillie latéralement des deux côtés du boîtier 8 qui la porte de façon à pouvoir coulisser dans les fentes 97 que présentent deux glissières – ou guide-carte – opposées 98. Comme le montre la figure 9, les guide-carte 98 comprennent un pied 99 présentant des tenons 101 par lesquels il est positionné latéralement relativement d'une part à une plaque 102 faisant partie du fond 3 et d'autre part aux rangées de connexions 4 qui sont fixées au circuit imprimé 103 et font saillie vers l'intérieur du bac 1 par des lumières allongées pratiquées dans la plaque 102.

Les guide-carte 98 comportent du côté opposé au fond 3 du bac 1 une tête élargie 104 ayant sensiblement même largeur que les boîtiers 8 et que les pieds 99. Les parois opposées 2 du bac 1, parallèles aux cartes 7, sont reliées entre elles par deux paires de traverses profilées 106. Chaque paire est montée à l'extérieur d'une paroi à claire-voie constituée par un alignement côte à côte de glissières 98. De chaque côté, l'une des traverses 106 est appuyée contre une aile arrière 107 du pied 99 des glissières 98. L'autre traverse 106 est montée contre les têtes 104 et engagée derrière une lèvre 108 que présente chaque tête 104 en direction du fond 3 du bac 1, de façon à empêcher le basculement des glissières 98 dans les deux sens.

Comme le montrent les figures 9 et 10, les têtes 104 présentent un chanfrein 109 élargissant l'entrée entre les glissières 98, et les boîtiers présentent une tête trapézoïdale 111 de profil correspondant à cette entrée. La face du boîtier 8 tournée vers le bornier 13, présente une ouverture 112 (représentée schématiquement) pour le fond 58 du bornier 13, et aux extrémités de celle-ci deux surfaces-supports d'informations graphiques 113.

Le bornier 13 est plus long que le boîtier 8 de façon à recouvrir encore deux rebords 114 qui sont portés par les glissières 98 au-delà des chanfreins 109 et sont dirigés vers l'extérieur du bac 1. De part et d'autre du fond 58, qui ne s'étend pas sur toute la longueur du bornier 13, le corps 52 du bornier est traversé par deux fenêtres 116 qui coïncident avec les surfaces de marquage 113 quand le bornier est emboîté dans l'ouverture 112 du boîtier 8.

Dans sa tête trapézoïdale 111, le boîtier porte de façon rotative deux loquets 117 montés chacun dans une lumière pratiquée dans l'une des faces latérales étroites du boîtier. Comme le montre schématiquement la figure 9, le fond 58 du bornier 13, lorsqu'il est emboîté dans le boîtier 8, force les loquets 117 vers l'extérieur contre la tête 104 des glissières 98 dans une position où un bec terminal 118 des loquets 117 est engagé derrière un épaulement 119 que présente la tête 104 en direction du fond 3 du bac 1.

Ainsi, à partir de la position de service, le boîtier 8 ne peut être coulissé vers l'extérieur du bac 1 tant que le bornier 13 n'a pas été extrait du boîtier 8.

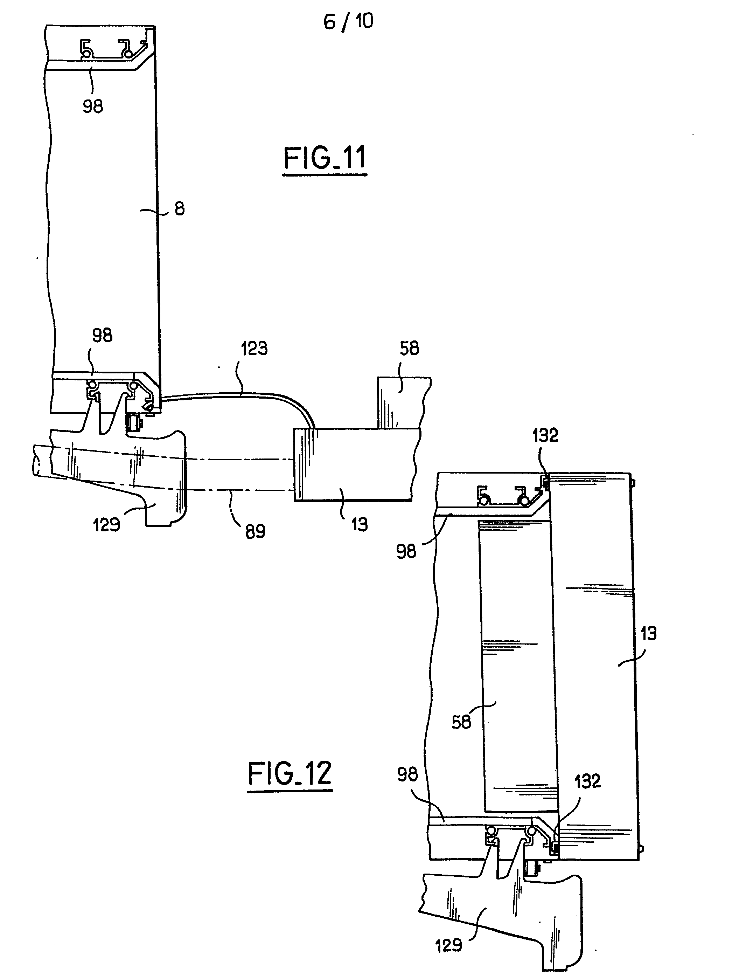

Chaque fenêtre 116 est séparée de l'extrémité adjacente du bornier 13 par une goulotte 121 s'ouvrant du côté opposé au boîtier 8. Le fond de chaque goulotte 121 est traversé par une fente 122. Dans celle qui se trouve en service en bas (figure 10) est montée à coulisse une lanière 123 dont les deux extrémités sont munies de surépaisseurs d'arrêt 124. Le brin de la lanière 123 qui est du côté du circuit imprimé est en service engagé à coulisse dans une fente 126 que présente la tête 104 dans le rebord 114. Comme le montre la figure 12, la longueur de la lanière 123 est suffisante pour permettre le déboîtement du bornier 13 bien dans l'axe du boîtier 8. Le guide-carte 98 du haut (figure 10) présente lui aussi une fente 126 permettant le montage d'une lanière 123, car dans le cas de bacs à double hauteur il est pratique de pouvoir ouvrir vers le haut les boîtiers n'ayant que la demi-hauteur du bac et situés au-dessus d'un autre demi-boîtier semblable.

Comme le montrent la figure 14 en cours de câblage et la figure 15 une fois le câblage terminé, les fils partant des ouvertures 90 entre les entretoises 88 sont tous dirigés vers la goulotte 121 où est déjà montée la lanière 123 et empêchent en service celle-ci de coulisser vers l'extérieur.

Un cavalier 127 (figure 10) est vissé dans l'ouverture de la goulotte 121 occupée par les fils et y maintiennent ceux-ci.

Seule la surface de marquage 113 du haut peut être utilisée, l'autre étant cachée par les fils 89 lorsque le bornier est en place. Cependant, la situation est inversée dans le cas évoqué plus haut de certains boîtiers dans les bacs de hauteur double.

Comme le montre la figure 9, les traverses 106 présentent des ailes terminées vers l'extérieur du bac 1 par des crochets 128 sur lesquels peut être encliquetée une série de guide-fils 129 (un par boîtier 8). Seule la face inférieure du bac 1 porte de tels guide-fils sauf dans le cas des bacs à double hauteur évoqués plus haut. Les guide-fils ont une paroi de fond 131 qui est sensiblement écartée du bac 1 de façon qu'au câblage une certaine longueur des fils soit nécessairement comprise entre le guide-fils 129 et la goulotte 121. Il est ainsi possible de déboîter le bornier 13 du boîtier 8 sans tirer exagérément sur les fils 89 et sans mettre le bornier 13 de travers.

Les goulottes 121 portent encore sur leur face dirigée en service vers le boîtier 8 chacune un crochet 132 dirigé vers le bas. Le bornier 13, lorsqu'il est engagé à fond dans le boîtier 8, est en butée contre le bord 130 (figure 4) que présente la paroi 51 du boîtier 8. Les crochets 132 sont voisins mais écartés du rebord 114 de chaque glissière 98 (figure 9).

Comme le montrent les figures 10 et 12, les crochets 132 permettent, en l'absence du boîtier 8, de prépositionner le bornier 13 pour faire le câblage. Il suffit pour cela d'engager chaque crochet 132 dans un évidement 133, dirigé vers le haut, que présente chaque glissière 98 sur le rebord 104.

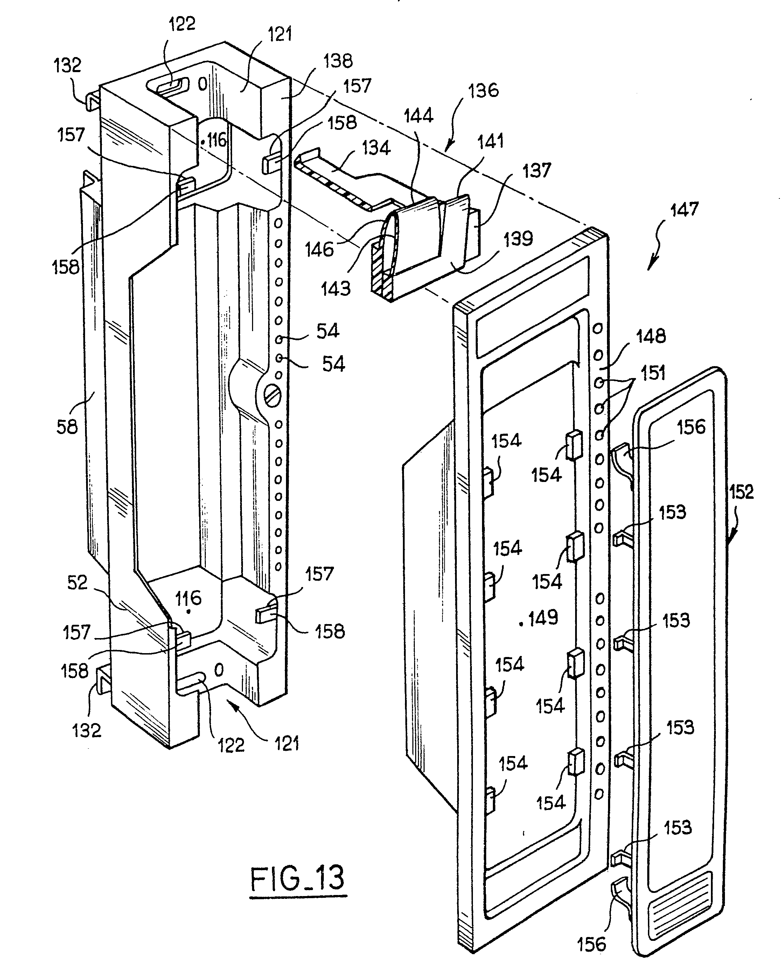

La fente 122 (figures 10 et 13) qui n'est pas occupée par la languette 123, c'est-à-dire la fente 122 du haut dans l'exemple représenté, reçoit un crochet d'encliquetage 134 appartenant à une charnière en matière plastique 136 présentant encore une aile 137 perpendiculaire au crochet 134 et appliquée contre la face externe 138 du corps de boîtier 52 quand le crochet 134 est en prise dans la fente 122. La charnière présente encore une aile mobile 139 articulée à l'aile 137 et à la languette 134 par un amincissement 141. Les ailes 137 et 139 présentent une ouverture rectangulaire 142 (figure 10) dont les deux bords parallèles au plan de l'aile 134 sont reliés par une aile mince 143 articulée par un amincissement 144 à une aile 146 d'épaisseur intermédiaire ayant une certaine flexibilité. Les amincissements 144 et 141 sont parallèles mais non alignés de sorte que les mouvements rotatifs de l'aile 139 autour de l'amincissement 141 ne peuvent avoir lieu sans flexion dans l'aile semi-épaisse 146. Il y a une position stable d'ouverture représentée à la figure 10 où l'aile 139 est dirigée vers l'extérieur à l'opposé de l'aile 137. En faisant pivoter l'aile 139 en direction opposée au crochet 134, on passe par un point dur avant d'atteindre la position de fermeture représentée à la figure 13 où l'aile 139 est rabattue contre l'aile 137.

L'aile 139 de la charnière 136 est fixée au dos d'un couvercle 147 qui est représenté schématiquement à la figure 10 et va être décrit en détail en référence à la figure 13. Il comprend un cadre 148 entourant une fenêtre 149 et présentant sur l'un de ses montants longitudinaux une série d'orifices 151 dont chacun vient en correspondance avec l'un des canaux optiques 54 du corps de bornier 52.

Le couvercle 147 comprend encore un porte-étiquette 152 qui porte sur sa face interne, le long de ses côtés longitudinaux, des tenons 153 dirigés vers le corps de boîtier 52 et dont l'extrémité est coudée vers l'extérieur. Les tenons 153 sont en service engagés derrière des bossages 154 qui sont portés par les montants longitudinaux du cadre 148 et font saillie dans la fenêtre 149, de sorte que le porte-étiquette 152 peut coulisser relativement au cadre 148 dans les sens de leur longueur. Le porte-étiquette 152 porte encore sur sa face interne quatre crochets 156 tous dirigés en service vers le haut et qui sont engagés dans la fenêtre 149 du cadre 148 pour coopérer avec des épaulements d'arrêt 157 constitués par la face interne d'ergots 158 faisant saillie deux à deux l'un vers l'autre dans les fenêtres 116 du corps de boîtier 52. Ainsi, lorsque le porte-étiquette 152 est déplacé vers le haut relativement au cadre 148 et que le couvercle 147 est fermé, les crochets 156 sont engagés derrière les ergots 157 et l'ouverture du couvercle est impossible. Pour ouvrir le couvercle 147, on déplace le porte-étiquette 152 vers le bas, ce qui dégage les crochets 156 des ergots 157, et on fait pivoter le couvercle 147 vers le haut où il est maintenu par la charnière à point dur.

On remarque encore sur la figure 13 que les canaux 54 sont répartis en deux groupes d'égal nombre entre lesquels est montée en rotation, sans possibilité de coulissement, une vis à pas rapide 158 destinée à être vissée dans le boîtier 8 pour assurer la fixation du bornier au boîtier, et si besoin est, pour aider à extraire le bornier 13 du boîtier 8 par simple rotation de la vis 158 dans le sens du dévissage.

Selon un aspect important de l'invention, le dispositif entrée/sortie qui vient d'être décrit peut faire partie d'une gamme de dispositifs entrée/sortie qui peuvent être conformes à ce qui vient d'être décrit en référence aux figures 2 à 15 excepté les liaisons électriques 18, 19, 21 entre les bornes internes 12 et les bornes externes 14.

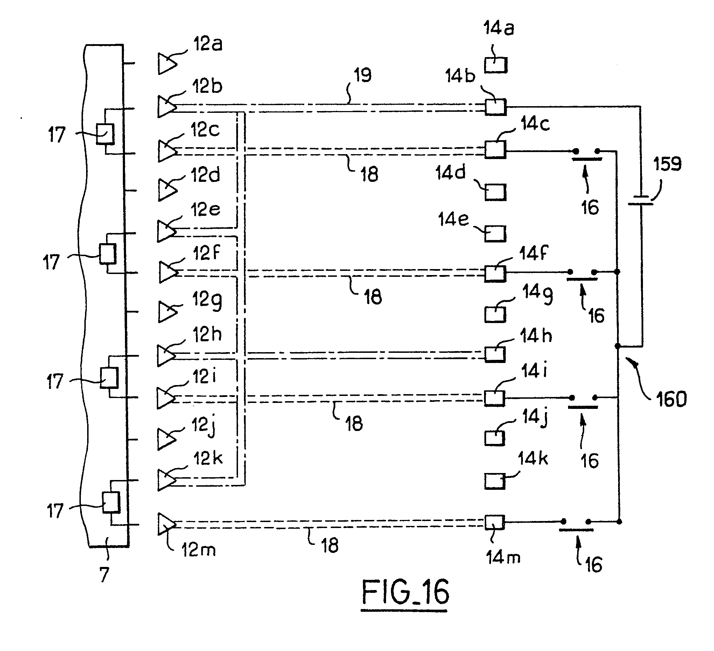

Dans un autre dispositif entrée/sortie représenté à la figure 16 et faisant partie de la même gamme, les liaisons électriques sont les mêmes que dans l'exemple des figures 2 à 15, excepté que le shunt 21 a été supprimé.

Dans ce cas, on bénéficie toujours des commodités de branchement à la carte 7 sans que celle-ci nécessite de comporter un point de potentiel commun. Par contre, du côté des bornes extérieures 14, il faut un bornier auxiliaire 160 entre la source 159 et les différents organes 16 à surveiller.

Le même schéma aurait pu être fait pour une carte de sortie en remplaçant les contacts 16 par les actionneurs 22, et les voies 17 par des interrupteurs électroniques 23.

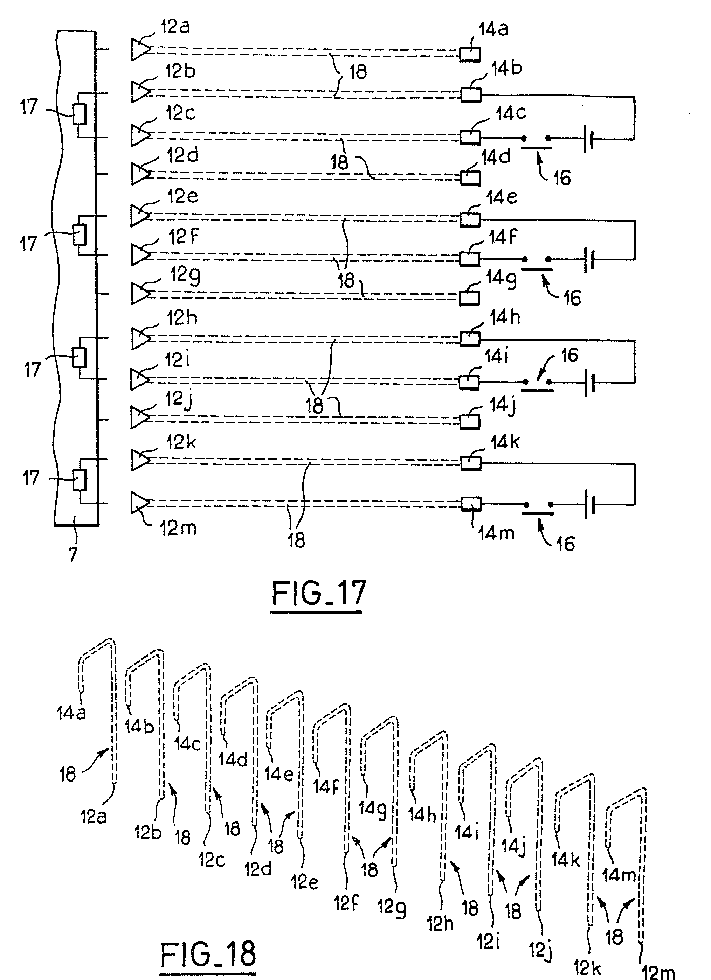

Dans un autre dispositif de la même gamme, représenté aux figures 17 et 18, les shunts 19 et 21 sont totalement supprimés et une liaison 18 est prévue dans chaque plan élémentaire entre la borne interne 12 et la borne externe 14. On réalise ainsi un bornier dit «transparent» qui n'apporte plus les facilités de câblage des réalisations des figures 2 à 16, mais qui peut être préféré pour la grande liberté qu'il laisse quant au schéma de câblage et quant à la disposition des circuits électroniques sur la carte 7.

Selon le procédé conforme à l'invention pour réaliser les différents borniers de la gamme 13, il convient de prévoir en stock des corps 52 tous identiques équipés de canaux lumineux 54 et éventuellement d'un couvercle 147 avec porte-étiquette 152, de fonds de borniers 58 également tous identiques et équipés d'une batterie de basculeurs 93 d'étriers 70, 75, 73 tous identiques et munis d'une vis de connexion 78 et d'un écrou 80, des liaisons 18 toutes identiques, des shunts 19 tous identiques et des shunts 21 tous identiques. La particularisation du bornier résultera uniquement du choix fait parmi les liaisons électriques 18, 19 et 21 au cours du montage et de la disposition donnée à ces liaisons dans le bornier 13.

Grâce à la gamme de dispositifs et au procédé pour leur réalisation, le fabricant peut proposer à l'utilisateur un choix de borniers répondant à toutes les situations courantes tout en encourant pour les borniers proprement dits, des frais à peine supérieurs à ceux qui résulteraient d'un type unique. L'économie est encore renforcée du fait que toutes les cartes 7 peuvent être identiques pour un ensemble de fonctions données, le fait que l'on travaille en voies isolées, en potentiel commun positif ou négatif n'ayant plus nécessairement de répercussion sur la carte. L'utilisateur bénéficie bien entendu de ces économies, et il est en outre en mesure, grâce à l'invention, de se dispenser des borniers auxiliaires dès que cela est possible.

Il a été possible de réaliser dans le bornier côte à côte une rangée de voyants lumineux 54, une rangée de vis 76 et une rangée d'orifices 90 pour l'introduction des fils 89 de sorte que dans chaque plan élémentaire, il y a le fil 89, la vis 76 et un voyant 54 correspondants. De plus, la vis 76 et la direction d'introduction du fil 89 sont perpendiculaires au circuit imprimé 103 et parallèles à la carte 7, ce qui facilite grandement le travail de câblage.

D'une façon générale, la réalisation décrite est remarquable par sa fonctionnalité et sa commodité d'emploi.

Un autre dispositif de la gamme précitée pourrait comporter le shunt 21, mais non le shunt 19.

Ce modèle permettrait de se dispenser du bornier auxiliaire 160, mais par contre une carte spéciale à point commun devra être employée si l'on désire qu'un tel point commun existe.

On pourrait aussi envisager de réaliser plusieurs gammes différant par exemple par la longueur des boîtiers et des borniers, certains étant prévus pour des bacs double ou triple hauteur.

Par ailleurs, l'invention n'est nullement incompatible avec les cartes comportant des voies ayant trois bornes, l'une d'elles pouvant comme pour les voies à deux bornes être reliée par un shunt tel que 19 contenu dans le boîtier à une borne interne associée à une autre voie de la carte.

## Revendications

1. Dispositif d'entrée/sortie connectable par un BUS (103) à une unité centrale d'un appareil pour la commande d'automatismes industriels tel qu'un automate programmable, ce dispositif comprenant au moins une carte (7) supportant un certain nombre de voies électroniques (17, 23) de traitement et de transmission des signaux échangés entre le BUS (103), et des appareillages comprenant des capteurs (16) envoyant des signaux en entrée ou des actionneurs (22) auxquels sont délivrés des signaux de commande en sortie, chaque carte (7) étant connectée au BUS (103) et à un bornier (13) comprenant une série de bornes internes (12) destinées à être branchées sur la carte (7) et une série de bornes externes (14) de liaison avec les capteurs (16) ou les actionneurs (22) chaque voie électronique (17, 23) se trouvant en service incluse dans un circuit d'entrée/sortie en série avec une borne interne (12c, 12f, 12i, 12m) et une borne externe (14c, 14f, 14i, 14m) reliées électriquement, le dispositif comprenant en outre des moyens (19, 21) pour interconnecter certains au moins des circuits d'entrée/sortie, caractérisé en ce qu'une partie au moins des moyens d'interconnexion (19, 21) est portée par le bornier (13).

2. Dispositif conforme à la revendication 1, caractérisé en ce que dans l'une au moins des deux séries de bornes (12, 14) chacune de certaines au moins des voies électroniques (17, 23) est associée à une seconde borne (12b, 12e, 12h, 12k, 14d, 14e, 14j, 14k), et en ce que les secondes bornes d'une même série sont reliées entre elles par un shunt respectif (19, 21) monté dans le bornier (13).

3. Dispositif conforme à la revendication 2, caractérisé en ce que le shunt (19) relie entre elles au moins deux bornes internes (12b, 12e, 12h, 12k) du bornier (13), et en ce que les voies électroniques (17, 23) sont isolées électriquement sur les cartes (7) et comportent chacune sur celles-ci au moins deux contacts (33, 34) associables chacun à une borne interne respective (12) du bornier (13).

4. Dispositif conforme à la revendication 3, caractérisé en ce que le shunt (19) fait partie d'une liaison ramifiée entre les secondes bornes internes (12b, 12e, 12h, 12k) et une borne externe (14b) de branchement à une source de potentiel.

5. Dispositif conforme à l'une des revendications 1 à 4, caractérisé en ce que l'une au moins des voies (17, 23) est associée à une seconde borne externe (14d, 14e, 14j, 14k), en ce que le dispositif comprend en outre une borne externe d'alimentation (14a) et en ce qu'un shunt (21) porté par le bornier (13) relie la borne externe d'alimentation (14a) et la seconde borne externe (14d, 14e, 14j, 14k) associée à la voie électronique (17, 23) précitée.

6. Dispositif conforme à la revendication 5, caractérisé en ce que le shunt (21) reliant la seconde borne externe (14d, 14e, 14j, 14k) et la borne externe d'alimentation (14a) fait partie d'une liaison ramifiée qui est encore reliée à une borne interne d'alimentation (12a).

7. Dispositif conforme à l'une des revendications 2 à 5, caractérisé en ce que le bornier (13) comprend au moins deux borniers partiels dont chacun présente au moins une borne externe d'alimentation (14a, 14b) et au moins une seconde borne (12b, 12e, 12h, 12k, 14d, 14e, 14j, 14k) reliée par un shunt (19, 21) à la borne externe d'alimentation (14a, 14b) et en ce que dans l'un au moins des borniers partiels, le shunt est en outre branché sur une borne externe de report d'alimentation (14g, 14h).

8. Gamme de dispositifs entrée/sortie connectables par un BUS (103) à une unité centrale d'un appareil pour la commande d'automatismes industriels tel qu'un automate programmable, cette gamme comprenant au moins un dispositif entrée/sortie conforme à l'une des revendications 1 à 7, les dispositifs de la gamme comportant au moins une carte (7) supportant un certain nombre de voies électroniques (17, 23) de traitement et de transmission des signaux échangés entre le BUS (103) et des appareillages comprenant des capteurs (16) envoyant des signaux en entrée ou des actionneurs (22) auxquels sont délivrés des signaux de commande en sortie, chaque carte (7) étant connectée au BUS (103) et à un bornier (13) comprenant une série de bornes internes (12) destinées à être branchées sur la carte (7), une série de bornes externes (14) de liaison avec les capteurs ou les actionneurs (16, 22), caractérisée en ce que les borniers (13) de tous les dispositifs de la gamme comprennent des carcasses isolantes (52, 58) sensiblement identiques, et diffèrent par la conformation des liaisons électriques (18, 19, 21) qui sont rapportées à leur intérieur entre les bornes externes (14) et internes (12).

9. Gamme de dispositifs entrée/sortie conforme à la revendication 8, caractérisée en ce que les bornes internes (12) sont portées par les liaisons électriques.

10. Gamme de dispositifs entrée/sortie conforme à l'une des revendications 8 ou 9, caractérisée en ce que les circuits électroniques (17, 23) sont isolés électriquement sur les cartes (7) et comportent chacun au moins deux contacts externes (33, 34) destinés à être associés chacun à une borne interne respective du bornier (13).

11. Procédé pour réaliser le bornier d'un dispositif entrée/sortie conforme à l'une des revendications 1 à 7 ou faisant partie d'une gamme conforme à l'une des revendications 8 à 10, selon lequel on réalise une carcasse isolante (52, 58) dans laquelle on aménage une série de bornes internes (12) adaptables à des contacts (33, 34) portés par la carte (7), et une série de bornes externes (14) pour la liaison avec les appareillages (19, 22), et on relie entre elles les bornes internes (12) et externes (14) selon un schéma électrique déterminé, caractérisé en ce que pour relier ainsi entre elles les bornes internes (12) et externes (14), on réalise un ensemble de liaisons électriques (18, 19, 21) dont certaines sont conformées pour relier entre elles directement et indépendamment des autres bornes une borne interne (123) et une borne externe (14) destinées à se correspondre, et d'autres sont conformées pour relier entre elles deux bornes de la même série au moins, et en ce qu'on réalise le schéma électrique voulu pour le bornier en montant dans la carcasse (52, 58) des liaisons (18, 19, 21) choisies parmi l'ensemble précité.

12. Dispositif conforme à l'une des revendications 1 à 7, ou faisant partie de la gamme conforme à l'une des revendications 8 à 10, caractérisé en ce que la carte est montée dans un boîtier (8) dans lequel le bornier (13) est emboîtable, en ce que la carte (7) porte un connecteur femelle (11) s'ouvrant vers le bornier (13), en ce que les liaisons électriques (18, 19, 21) du bornier (13) sont constituées par des conducteurs rigides présentant des extrémités qui constituent les bornes internes (12) et dont la direction d'introduction ou d'extraction dans le connecteur femelle (11) est sensiblement parallèle à la direction d'introduction ou d'extraction du bornier (13) dans le boîtier (8).

13. Dispositif conforme à la revendication 12, caractérisé en ce qu'il comprend une lanière (123) de retenue du bornier (13), cette lanière (123) ayant une longueur permettant le déboîtement complet du bornier (13) quand le boîtier (8) est en position de service relativement au BUS (103).

14. Dispositif conforme à l'une des revendications 12 ou 13, caractérisé en ce que le boîtier (8) est monté de façon coulissante entre deux glissières latérales (98), et en ce que la lanière (123) est portée de façon coulissante relativement à l'une des glissières (98) et comporte une saillie d'arrêt (124) au voisinage de l'une de ses extrémités.

15. Dispositif conforme à la revendication 14, caractérisé en ce que les deux glissières latérales (98) et les deux extrémités du bornier (13) présentent des moyens (122) d'association à une lanière (123).

16. Dispositif conforme à la revendication 15, caractérisé en ce que sur le bornier (13), ces moyens (122) sont aménagés au fond d'une goulotte (121) de passage des fils (89) et en ce que du côté opposé à la sortie des fils (89), ces moyens (122) sont aptes à recevoir un crochet d'encliquetage (134) appartenant à une charnière (136) reliant le bornier (13) à un couvercle de bornier (147).

17. Dispositif conforme à l'une des revendications 12 à 16, caractérisé en ce qu'il comprend encore un guide-fil (129) fixé à un bâti (1) le long de l'une des petites faces latérales du boîtier (8), et en ce que ce guide-fil (129) comporte une paroi de fond (131) positionnée relativement au bornier (13) de façon que le bornier (13) puisse être déboîté du boîtier (8) sans tirage excessif sur les fils (89).

18. Dispositif conforme à l'une des revendications 12 à 17, caractérisé en ce qu'une vis à pas rapide (158) est montée en rotation sans possibilité de coulissement dans le bornier (13) et est vissée dans le boîtier (8) lorsque le bornier y est complètement emboîté.

19. Dispositif conforme à l'une des revendications 12 à 18, caractérisé en ce que le boîtier (13) comprend dans l'une au moins de ses parois latérales, dans la zone recevant le bornier (13) à l'emboîtement, un loquet (117) qui, lorsque le bornier (13) est engagé dans le boîtier (8), est repoussé vers l'extérieur et ainsi amené en prise derrière un organe d'arrêt (119) rendu solidaire d'un bâti (1).

20. Dispositif conforme à l'une des revendications 12 à 19, caractérisé en ce qu'il comprend un bloc à fusibles (37) encliqueté sur la carte entrée/sortie (7) et accessible par une trappe amovible (51) du boîtier (8).

21. Dispositif conforme à l'une des revendications 12 à 20, caractérisé en ce que le bornier (13) porte sur sa face dirigée vers le circuit imprimé (103), des moyens d'accrochage (132) destinés à venir en prise avec des moyens conjugués (133) rendus solidaires d'un bâti (1), le boîtier (8) portant des moyens (130) définissant pour le bornier (13) en fin d'emboîtement, une position dans laquelle les moyens d'accrochage (132) du bornier sont écartés desdits moyens conjugués (133).

22. Dispositif conforme à la revendication 21, caractérisé en ce que lesdits moyens conjugués (133) sont portés par des glissières (98) de coulissement du boîtier (8) relativement au circuit imprimé (103).

23. Dispositif conforme à l'une des revendications 12 à 22, caractérisé en ce que le bornier (13) comporte au voisinage de l'une au moins de ses extrémités une fenêtre (116) et en ce que le boîtier (8) présente face à cette fenêtre (116), en dehors d'une ouverture (112) destinée à recevoir le bornier (13) à l'emboîtement, un support d'information graphique (113).

24. Dispositif conforme à la revendication 23, caractérisé en ce qu'une telle fenêtre (116) est prévue à chaque extrémité du bornier (13), entre les bornes (14) et une goulotte (121) de sortie des fils (89), en ce que les fils (89) vont des bornes (14) à l'une seulement des goulottes (121), et en ce que des informations graphiques sont portées sur le support (113) qui coïncide avec la fenêtre (116) opposée aux fils (89).

25. Dispositif conforme à l'une des revendications 12 à 24, caractérisé en ce que le bornier (13) est associé à un couvercle (147) articulé à l'une de ses extrémités, en ce que le couvercle (147) est traversé par une fenêtre (149) recouverte par un porte-étiquette (152), en ce que le porte-étiquette (152) porte des crochets de verrouillage (156) engagés dans la fenêtre (149) du couvercle (147) pour coopérer avec des épaulements d'arrêt (157) portés par le bornier (13) et en ce que, relativement au couvercle (147), le porte-étiquette (152) est monté à coulissement entre une position de verrouillage dans laquelle, lorsque le couvercle (147) est fermé, les crochets de verrouillage (156) sont en prise avec les épaulements d'arrêt (157) de façon à empêcher l'ouverture, et une position de déverrouillage.

26. Dispositif conforme à l'une des revendications 1 à 7 ou 12 à 25, ou faisant partie d'une gamme selon l'une des revendications 8 à 10, caractérisé en ce que le bornier (13) présente, en direction opposée à la carte entrée/sortie (7), une rangée de voyants lumineux (54), une rangée de vis (76) de serrage des fils (89) dans les bornes externes (14) et une rangée d'orifices (90) d'introduction d'un fil (89) dans une borne externe (14), ces orifices et les vis étant orientés pour que les fils (89) y soient engagés sensiblement parallèlement à la carte (7), chaque voyant lumineux (54) étant adjacent à une borne (14) dont il permet de contrôler l'état.

27. Dispositif conforme à la revendication 26, caractérisé en ce que chaque voyant lumineux comprend une source lumineuse (56) montée sur la carte entrée/sortie (7) et un conduit optique (54) traversant le bornier (12).

28. Dispositif conforme à l'une quelconque des revendications 26 ou 27, caractérisé en ce que chaque borne externe (14) comprend un dispositif de renvoi d'angle (93) entre l'extrémité de la vis (76) et une pièce associée (96) d'appui sur le fil (89).

**Patentansprüche**

1. Eingabe/Ausgabevorrichtung, die durch einen Bus (103) an die Zentraleinheit eines Geräts zur Steuerung industrieller, automatischer Abläufe, wie ein programmierbarer Automat, angeschlossen werden kann, mit mindestens einer Karte (7), die eine bestimmte Anzahl Strompfade (17, 23) zum Verarbeiten und Übermitteln von Signalen trägt, die zwischen dem Bus (103) und Einrichtungen mit Aufnehmern (16), die Eingangssignale schicken, oder Betätigungsgliedern (22), die Steuerausgangssignale erhalten, ausgetauscht werden, wobei jede Karte (7) mit dem Bus (103) und einem Anschlussträger (13) verbunden ist, der eine Reihe innerer Anschlüsse (12), die an die Karte (7) anzuschliessen sind, und eine Reihe äusserer Anschlüsse (14) zur Verbindung mit den Aufnehmern (16) oder den Betätigungsgliedern (22) enthält, und jeder Strompfad (17, 23) im Betriebszustand in einem Eingabe/Ausgabekreis in Reihe mit einem inneren Anschluss (12c, 12f, 12i, 12m) und einem äusseren Anschluss (14c, 14f, 14i, 14m), die elektrisch verbunden sind, eingeschlossen ist, und die Vorrichtung weiterhin Mittel (19, 21) zum Verbinden mindestens bestimmter Eingabe/Ausgabekreise miteinander enthält, dadurch gekennzeichnet, dass mindestens ein Teil der Verbindungsmittel (19, 21) vom Anschlussträger getragen wird.

2. Vorrichtung nach Anspruch 1, dadurch gekennzeichnet, dass in mindestens einer der beiden Anschlussreihen (12, 14) jeder von mindestens bestimmten Strompfaden (17, 23) einem zweiten Anschluss (12b, 12e, 12h, 12k, 14b, 14e, 14j, 14k) zugeordnet ist und dass die zweiten Anschlüsse ein und derselben Reihe untereinander durch ein entsprechendes Überbrückungsglied (19, 21), das im Anschlussträger (13) eingebracht ist, verbunden sind.

3. Vorrichtung nach Anspruch 2, dadurch gekennzeichnet, dass das Überbrückungsglied (19) mindestens zwei innere Anschlüsse (12b, 12e, 12h, 12k) des Anschlussträgers (13) untereinander verbindet, und dass die Strompfade (17, 23) auf den Karten (7) elektrisch isoliert sind und auf diesen je mindestens zwei Kontakte (33, 34) enthalten, die je einem entsprechenden inneren Anschluss (12) des Anschlussträgers (13) zugeordnet werden können.

4. Vorrichtung nach Anspruch 3, dadurch gekennzeichnet, dass das Überbrückungsglied (19) Teil einer verzweigten Verbindung zwischen den zweiten inneren Anschlüssen (12b, 12e, 12h, 12k) und einem zur Verbindung mit einer Potentialquelle bestimmten äusseren Anschluss (14b) ist.

5. Vorrichtung nach einem der Ansprüche 1 bis 4, dadurch gekennzeichnet, dass mindestens einer der Strompfade (17, 23) einem zweiten, äusseren Anschluss (14d, 14e, 14j, 14k) zugeordnet ist, dass die Vorrichtung weiterhin einen äusseren Versorgungsanschluss (14a) enthält und dass ein Überbrückungsglied (21), das vom Anschlussträger (13) getragen wird, den äusseren Versorgungsanschluss (14a) und den zweiten äusseren Anschluss (14d, 14e, 14j, 14k) verbindet, der dem vorher genannten Strompfad (17, 23) zugeordnet ist.

6. Vorrichtung nach Anspruch 5, dadurch gekennzeichnet, dass das Überbrückungsglied (21), das den zweiten äusseren Anschluss (14d, 14e, 14j, 14k) und den äusseren Versorgungsanschluss (14a) verbindet, Teil einer verzweigten Verbindung ist, die zusätzlich mit einem inneren Versorgungsanschluss (12a) verbunden ist.

7. Vorrichtung nach einem der Ansprüche 2 bis 5, dadurch gekennzeichnet, dass der Anschlussträger (13) mindestens zwei Teilanschlussträger enthält, die jeweils mindestens einen äusseren Versorgungsanschluss (14a, 14b) und mindestens einen zweiten Anschluss (12b, 12e, 12h, 12k, 14d, 14e, 14j, 14k) aufweisen, der durch ein Überbrückungsglied (19, 21) mit dem äusseren Versorgungsanschluss (14a, 14b) verbunden ist, und dass in mindestens einem der Teilanschlussträger das Überbrückungsglied zusätzlich an einen äusseren Anschluss (14g, 14h) zum Weiterleiten der Versorgung angeschlossen ist.

8. Reihe von Eingabe/Ausgabevorrichtungen, die über einen Bus (103) an eine Zentraleinheit eines Geräts zur Steuerung industrieller, automatischer Vorgänge, wie ein programmierbarer Automat, angeschlossen werden können, wobei diese Reihe mindestens eine Eingabe/Ausgabevorrichtung nach einem der Ansprüche 1 bis 7 enthält, die Vorrichtungen der Reihe mindestens eine Karte (7) enthalten, die eine bestimmte Anzahl Strompfade (17, 23) zum Verarbeiten und Übermitteln von Signalen, die zwischen dem Bus (103) und Einrichtungen mit Aufnehmern (16), die Eingangssignale abschicken, oder Betätigungsgliedern (22), die die Ausgangssteuersignale erhalten, ausgetauscht werden, wobei jede Karte (7) an den Bus (103) und an einen Anschlussträger (13) angeschlossen ist, der eine Reihe innerer Anschlüsse (12), die an die Karte (7) anzuschliessen sind, und eine Reihe äusserer Anschlüsse (14) zur Verbindung mit den Aufnehmern oder den Betätigungsgliedern (16, 22) aufweist, dadurch gekennzeichnet, dass die Anschlussträger (13) aller Vorrichtungen der Reihe isolierende Haltestrukturen (52, 58) aufweisen, die im wesentlichen gleich sind, sich jedoch in der Gestaltung der elektrischen Verbindungen (18, 19, 21), die in ihrem Inneren zwischen den äusseren (14) und den inneren (12) Anschlüssen angebracht sind, unterscheiden.

9. Reihe von Eingabe/Ausgabevorrichtungen nach Anspruch 8, dadurch gekennzeichnet, dass die inneren Anschlüsse (12) von den elektrischen Verbindungen getragen werden.

10. Reihe von Eingabe/Ausgabevorrichtungen nach einem der Ansprüche 8 oder 9, dadurch gekennzeichnet, dass die elektronischen Schaltkreise (17, 23) auf den Karten (7) elektrisch isoliert sind und je mindestens zwei äussere Kontakte (33, 34) enthalten, die je mit einem entsprechenden inneren Anschluss des Anschlussträgers (13) zu verbinden sind.

11. Verfahren zur Herstellung des Anschlussträgers einer Eingabe/Ausgabevorrichtung nach einem der Ansprüche 1 bis 7 oder als Teil einer Reihe nach einem der Ansprüche 8 bis 10, wobei eine isolierende Haltestruktur (52, 58) hergestellt wird, in die eine Reihe innerer Anschlüsse (12), die in Zusammenwirken mit von der Karte (7) getragenen Kontakten (33, 34) gebracht werden können, und eine Reihe äusserer Anschlüsse (14) zur Verbindung mit den Einrichtungen (19, 22) angebracht werden, und die inneren (12) und äusseren (14) Anschlüsse nach einem vorher bestimmten Schaltschema verbunden werden, dadurch gekennzeichnet, dass zu einer derartigen Verbindung der inneren (12) und äusseren (14) Anschlüsse untereinander eine Menge elektrischer Verbindungen (18, 19, 21) hergestellt wird, von denen bestimmte ausgebildet sind, um direkt und unabhängig von anderen Anschlüssen einen inneren Anschluss (123) und einen äusseren Anschluss (14), die sich entsprechen sollen, untereinander zu verbinden, und andere ausgebildet sind, um mindestens zwei Anschlüsse derselben Reihe untereinander zu verbinden, und dadurch, dass das für den Anschlussträger gewünschte Schaltschema hergestellt wird, indem in dem Gehäuse (52, 58) Verbindungen (18, 19, 21) angebracht werden, die aus der vorher genannten Menge ausgewählt wurden.

12. Vorrichtung nach einem der Ansprüche 1 bis 7, oder Vorrichtung, die Teil der Reihe nach einem der Ansprüche 8 bis 10 ist, dadurch gekennzeichnet, dass die Karte in einem Gehäuse (8) angebracht ist, in das der Anschlussträger (13) eingesteckt werden kann, dass die Karte (7) ein Verbinder-Buchsenteil (11) trägt, das sich zum Anschlussträger (13) hin öffnet, und dass die elektrischen Verbindungen (18, 19, 21) des Anschlussträgers (13) durch steife Leiter mit Enden ausgeführt sind, die die inneren Anschlüsse (12) bilden und die in einer Richtung in das Verbinder-Buchsenteil (11) eingeführt und aus ihm herausgezogen werden, die im wesentlichen parallel ist zur Richtung, in der der Anschlussträger (13) in das Gehäuse (8) eingeführt und aus ihm herausgezogen wird.

13. Vorrichtung nach Anspruch 12, dadurch gekennzeichnet, dass sie einen Riemen (123) zum Herausziehen des Anschlussträgers (13) enthält, wobei dieser Riemen (123) eine Länge hat, die es ermöglicht, den Anschlussträger (13) vollständig zu entnehmen, wenn das Gehäuse (8) bezüglich zum Bus (103) in seiner Arbeitsposition ist.

14. Vorrichtung nach einem der Ansprüche 12 oder 13, dadurch gekennzeichnet, dass das Gehäuse (8) verschiebbar zwischen zwei Seitenschienen (98) angebracht ist, und dadurch, dass der Riemen (123) bezüglich einer der beiden Schienen (98) verschiebbar gehalten ist und in der Nähe einer seiner Enden einen Stopvorsprung (124) enthält.

15. Vorrichtung nach Anspruch 14, dadurch gekennzeichnet, dass die beiden Seitenschienen (98) und die beiden Enden des Anschlussträgers (13) Mittel (122) zum Zuordnen zu einem Riemen aufweisen.

16. Vorrichtung nach Anspruch 15, dadurch gekennzeichnet, dass auf dem Anschlussträger (13) diese Mittel (122) am Ende einer Rinne (121) zum Durchlass von Leitungen (89) angebracht sind und dass auf der dem Austritt der Leitungen (89) gegenüberliegenden Seite diese Mittel (122) einen Schnapphaken (134) aufnehmen können, der zu einem Scharnier (136) gehört, das den Anschlussträger (13) mit einem Anschlussträgerdeckel (147) verbindet.

17. Vorrichtung nach einem der Ansprüche 12 bis 16, dadurch gekennzeichnet, dass sie weiterhin einen Leitungsträger (129) enthält, der an einem Gestell (1) einer der kleinen Seitenflächen des Gehäuses (8) entlang angebracht ist, und dass dieser Leitungsträger (129) eine Grundwand (131) enthält, die so zum Anschlussträger (13) ausgerichtet ist, dass der Anschlussträger (13) aus dem Gehäuse (8) entnommen werden kann, ohne übermässig an den Leitungen (89) zu ziehen.

18. Vorrichtung nach einem der Ansprüche 12 bis 17, dadurch gekennzeichnet, dass eine drehbar und unverschiebbar im Anschlussträger (13) angebrachte Schraube (158) mit Schnellgewinde in das Gehäuse (8) geschraubt wird, wenn der Leitungsträger völlig in das Gehäuse eingesteckt ist.

19. Vorrichtung nach einem der Ansprüche 12 bis 18, dadurch gekennzeichnet, dass der Anschlussträger (13) in mindestens einer seiner beiden Seitenwände, in dem Bereich, der den Anschlussträger (13) beim Einstecken aufnimmt, eine Klinke (117) enthält, die, wenn der Anschlussträger (13) in das Gehäuse (8) eingeführt ist, nach aussen gedrückt wird und auf diese Weise hinter eine Anschlagvorrichtung (119), die mit dem Gestell (1) fest verbunden ist, einschnappt.

20. Vorrichtung nach einem der Ansprüche 12 bis 19, dadurch gekennzeichnet, dass sie einen Sicherungskasten (37) enthält, der auf der Eingabe/Ausgabekarte (7) eingerastet und durch eine entfernbare Klappe (51) des Gehäuses (8) zugänglich ist.

21. Vorrichtung nach einem der Ansprüche 12 bis 20, dadurch gekennzeichnet, dass der Anschlussträger (13) auf seiner der gedruckten Schaltung (103) zugewandten Seite Vorrichtungen zum Einhängen (132) aufweist, die in entsprechende, mit dem Gestell (1) fest verbundene Vorrichtungen (133) eingreifen, wobei das Gehäuse (8) Vorrichtungen (130) trägt, die für den Anschlussträger (13) am Ende des Einsteckens eine Stellung festlegen, in der die Vorrichtungen (132) zum Einhaken des Anschlussträgers von den ihnen entsprechenden Vorrichtungen (133) fortgespreizt sind.

22. Vorrichtung nach Anspruch 21, dadurch gekennzeichnet, dass die den Einhakvorrichtungen (132) entsprechenden Vorrichtungen (133) von Schienen (98) zum Verschieben des Gehäuses (8) relativ zur gedruckten Schaltung (103) getragen werden.

23. Vorrichtung nach einem der Ansprüche 12 bis 22, dadurch gekennzeichnet, dass der Anschlussträger (13) in der Nähe mindestens eines seiner beiden Enden ein Fenster (116) enthält, und dass das Gehäuse (8) diesem Fenster (116) gegenüberliegend, ausserhalb einer Öffnung (112) zum Aufnehmen des Anschlussträgers (13) beim Einstecken, einen graphischen Informationsträger (113) enthält.

24. Vorrichtung nach Anspruch 23, dadurch gekennzeichnet, dass ein derartiges Fenster (116) an jedem Ende des Anschlussträgers (13) zwischen den Anschlüssen (14) und einer Rinne (121) zum Herauslassen der Leitungen (89) vorgesehen ist, dass die Leitungen (89) von den Anschlüssen (14) zu nur einer der Rinnen (121) reichen und dass die graphischen Informationen auf dem Träger (113) getragen werden, der sich mit dem den Leitungen (89) gegenüberliegenden Fenster (116) deckt.

25. Vorrichtung nach einem der Ansprüche 12 bis 24, dadurch gekennzeichnet, dass der Anschlussträger (13) einem Deckel (147) zugeordnet ist, der an einem seiner Enden angelenkt ist, dass der Deckel (147) von einem Fenster (149) durchzogen ist, das mit einem Etikettenhalter (152) bedeckt ist, dass der Etikettenhalter (152) Verriegelungshaken (156) trägt, die in das Fenster (149) des Deckels (147) eingreifen, um mit vom Anschlussträger (13) getragenen Anschlagschultern (157) zusammenzuwirken, und dass, bezüglich des Deckels (147), der Etikettenhalter (152) verschiebbar zwischen einer Verriegelungsposition, in der, wenn der Deckel (147) geschlossen ist, die Verriegelungshaken (156) so in die Anschlagschultern (157) eingreifen, dass sie das Öffnen verhindern, und einer entriegelten Position angebracht ist.

26. Vorrichtung nach einem der Ansprüche 1 bis 7, oder 12 bis 25, oder Vorrichtung, die Teil einer Reihe nach einem der Ansprüche 8 bis 10 ist, dadurch gekennzeichnet, dass der Anschlussträger (13) in der Eingabe/Ausgabekarte (7) gegenüberliegender Richtung eine Reihe Leuchtanzeigen (54), eine Reihe Schrauben (76) zum Einklemmen der Leitungen (89) in die äusseren Anschlüsse (14) und eine Reihe Öffnungen (90) zum Einführen einer Leitung (89) in einen äusseren Anschluss enthält, wobei diese Öffnungen und die Schrauben so gerichtet sind, dass die Leitungen (89) von ihnen in etwa parallel zur Karte (7) aufgenommen werden, und jede Leuchtanzeige (54) einem Anschluss (14) benachbart ist, dessen Zustandskontrolle sie ermöglicht.

27. Vorrichtung nach Anspruch 26, dadurch gekennzeichnet, dass jede Leuchtanzeige eine Lichtquelle (26), die auf der Eingabe/Ausgabekarte (7) angebracht ist, und einen Lichtleiter (54), der den Anschlussträger (12) durchquert, enthält.

28. Vorrichtung nach einem der Ansprüche 26 oder 27, dadurch gekennzeichnet, dass jeder äussere Anschluss (14) eine winklige Umlenkeinrichtung (93) zwischen dem Ende der Schraube (76) und einem dazugehörigen Teil (96), das Druck auf die Leitung (89) ausübt, enthält.

**Claims**

1. An input/output device connectable by means of a bus (103) to a central unit of an apparatus for controlling industrial automatic equipments, such as a programmable auto-control, this device comprising at least one card (7) supporting a certain number of electronic channels (17, 23) processing and transmitting signals exchanged between the bus (103) and apparatuses incorporating sensors (16), sending input signals, or actuators (22), to which output control signals are delivered, each card (7) being connected to the bus (103) and to a terminal-box (13) comprising a series of inner terminals (12) intended to be connected to the card (7) and a series of outer terminals (14) for connection to the sensors (16) or actuators (22), each electronic channel (17, 23) being included, during operation, in an input/output circuit in series with an inner terminal (12c, 12f, 12i, 12m) and an outer terminal (14c, 14f, 14i, 14m) connected electrically, the device also possessing means (19, 21) of interconnecting at least some of the input/output circuits, characterized in that at least some of the interconnection means (19, 21) are carried by the terminal-box (13).

2. A device as claimed in claim 1, characterized in that, in at least one of the two series of terminals (12, 14), each of at least some of the electronic channels (17, 23) is associated with a second terminal (12b, 12e, 12h, 12k, 14d, 14e, 14j, 14k), and in that the second terminals belonging to the same one of the series are connected to one another by means of a respective shunt (19, 21) mounted in the terminal-box (13).

3. A device as claimed in claim 2, characterized in that the shunt (19) connects to one another at least two inner terminals (12b, 12e, 12h, 12k) of the terminal-box (13), and in that the electronic channels (17, 23) are isolated electrically on the cards (7), each said electronic channel having on said cards at least two contacts (33, 34) each of which can be associated with a respective inner terminal (12) of the terminal-box (13).

4. A device as claimed in claim 3, characterized in that the shunt (19) belongs to a branched connection between the second inner terminals (12b, 12e, 12h, 12k) and an outer terminal (14b) for connection to a potential source.

5. A device as claimed in one of claims 1 to 4, characterized in that at least one of the channels (17, 23) is associated with a second outer terminal (14d, 14e, 14j, 14k), in that the device moreover comprises an outer supply terminal (14a), and in that a shunt (21) carried by the terminal-box (13) connects the outer supply terminal (14a) and the second outer terminal (14d, 14e, 14j, 14k) associated with the abovementioned electronic channel (17, 23).

6. A device as claimed in claim 5, characterized in that the shunt (21) connecting the second outer terminal (14d, 14e, 14j, 14k) and the outer supply terminal (14a) belongs to a branched connection which is moreover connected to an inner supply terminal (12a).

7. A device as claimed in one of claims 2 to 5, characterized in that the terminal-box (13) comprises at least two partial terminal-boxes, each of which has at least one outer supply terminal (14a, 14b) and at least one second terminal (12b, 12e, 12h, 12k, 14d, 14e, 14j, 14k) the latter being connected by means of a shunt (19, 21) to the outer supply terminal (14a, 14b), and in that in at least one of the partial terminal-boxes, the shunt is moreover connected to an outer supply transfer terminal (14g, 14h).

8. A range of input/output devices connectable by means of a bus (103) to a central unit of an apparatus for controlling industrial automatic equipment, such as a programmable auto-control, this range comprising at least one input/output device as claimed in one of claims 1 to 7, the devices of the range comprising at least one card (7) supporting a certain number of electronic channels (17, 23) for processing and transmitting signals exchanged between the bus (103) and apparatuses comprising sensors (16), sending input signals, or actuators (22), to which output control signals are delivered, each card (7) being connected to the bus (103) and to a terminal-box (13) comprising a series of inner terminals (12) intended to be connected to the card (7) and a series of outer terminals (14) for connection to the sensors or the actuators (16, 22), characterized in that the terminal-boxes (13) of all the devices of the range possess substantially identical isolating casings (52, 58) and differ in the shaping of the electrical connections (18, 19, 21) which are attached to their inside between the outer terminals (14) and inner terminals (12).

9. A range of input/output devices as claimed in claim 8, characterized in that the inner terminals (12) are carried by the electrical connections.

10. A range of input/output devices as claimed in one of claims 8 or 9, characterized in that the electronic circuits (17, 23) are isolated electrically on the cards (7) and each possess at least two outer contacts (33, 34), each of which is intended to be associated with a respective inner terminal of the terminal-box (13).

11. A method of producing the terminal-box of an input/output device as claimed in one of claims 1 to 7 or forming part of a range as claimed in one of claims 8 to 10, comprising the steps of producing an isolating casing (52, 58), arranging therein a series of inner terminals (12) able to cooperate with contacts (33, 34) carried by the card (7), and a series of outer terminals (14) for connection to the apparatuses (19, 22), and connecting the inner terminals (12) and outer terminals (14) to one another according to a specific electrical diagram, characterized by, for so connecting the inner terminals (12) and outer terminals (14) to one another, providing a set of electrical connections (18, 19, 21), some of these being shaped so as to connect to one another directly and independently of the other terminals an inner terminal (123) and an outer terminal (14) which are intended to correspond to one another, and others being shaped so as to connect to one another at least two terminals of the same series, and producing the desired electrical diagram for the terminal-box by mounting in the casing (52, 58) connections (18, 19, 21) selected from the above-mentioned set.

12. A device as claimed in one of claims 1 to 7 or forming part of the range as claimed in one of claims 8 to 10, characterized in that the card is mounted in a housing (8), in which the terminal-box (13) can be fitted, in that the card (7) carries a female connector (11) opening towards the terminal-box (13), and in that the electrical connections (18, 19, 21) of the terminal-box (13) consist of rigid conductors having ends which form the inner terminals (12) and of which the direction of introduction into or extraction from the female connector (11) is substantially parallel to the direction of introduction or extraction of the terminal-box (13) into or from the housing (8).

13. A device as claimed in claim 12, characterized by comprising a lamella (123) for retaining the terminal-box (13), this lamella (123) having a length allowing the complete disengagement of the terminal-box (13) when the housing (8) is in the operating position relative to the bus (103).

14. A device as claimed in one of claims 12 or 13, characterized in that the housing (8) is mounted so as to slide between two lateral slides (98), and in that the lamella (123) is carried so as to slide relative to one of the slides (98) and has a stop projection (124) in the vicinity of one of its ends.

15. A device as claimed in claim 14, characterized in that the two lateral slides (98) and the two ends of the terminal-box (13) have means (122) of association with a lamella (123).

16. A device as claimed in claim 15, characterized in that on the terminal-box (13), said means (122) are provided adjacent the bottom of a trough (121) for the passage of the wires (89), and in that, on the side remote from the outlet of the wires (89), said means (122) are designed to receive a snap-in hook (134) belonging to a hinge (136) connecting the terminal-box (13) to a terminal-box cover (147).

17. A device as claimed in one of claims 12 to 16, characterized by moreover comprising a wire guide (129) fastened to a frame (1) along one of the small lateral faces of the housing (8), and by this wire guide (129) having a bottom wall (131) positioned relative to the terminal-box (13) in such a way that the terminal-box (13) can be disengaged from the housing (8) without excessive pulling on the wires (89).

18. A device as claimed in one of claims 12 to 17, characterized in that a fast-pitch screw (158) is mounted rotatably in the terminal-box (13) without the possibility of sliding and is screwed into the housing (8) when the terminal-box is fitted completely in the latter.

19. A device as claimed in one of claims 12 to 18, characterized in that the housing (13) comprises in at least one of its side walls, in the zone receiving the terminal-box (13) during fitting, a latch (117) which, when the terminal-box (13) is engaged in the housing (8), is pushed back outwards and thus brought into engagement behind a stop member (119) made stationary with respect to a frame (1).

20. A device as claimed in one of claims 12 to 19, characterized by comprising a fuse block (37) snapped onto the input/output card (7) and accessible via a removable trap-door (51) of the housing (8).

21. A device as claimed in one of claims 12 to 20, characterized in that the terminal-box (13) carries, on its face directed towards the printed circuit (103), hooking means (132) intended to engage with matching means (133) made stationary with respect to a frame (1), the housing (8) carrying means (130) which, at the end of fitting, define for the terminal-box (13) a position in which the terminal-box hooking means (132) are spaced apart from the said matching means (133).

22. A device as claimed in claim 21, characterized in that said matching means (133) are carried by slides (98) for the sliding of the housing (8) relative to the printed circuit (103).

23. A device as claimed in one of claims 12 to 22, characterized in that the terminal-box (13) possesses a window (116) in the vicinity of at least one of its ends, and in that the housing (8) has a graphical information support (113) opposite this window (116) outside an orifice (112) adapted for receiving the terminal-box (13) during fitting.

24. A device as claimed in claim 23, characterized in that such a window (116) is provided at each end of the terminal-box (13) between the terminals (14) and a trough (121) for the outlet of the wires (89), in that the wires (89) extend from the terminals (14) to only one of the troughs (121), and in that graphical information is carried on the support (113) which coincides with the window (116) which is remote from the wires (89).

25. A device as claimed in one of claims 12 to 24, characterized in that the terminal-box (13) is associated with a cover (147) articulated at one of its ends, in that a window (149) covered by a label holder (152) passes through the cover (147), in that the label holder (152) carries locking hooks (156) engaged in the window (149) of the cover (147) so as to interact with stop shoulders (157) carried by the terminal-box (13), and in that relative to the cover (147), the label holder (152) is mounted to slide between a locking position, in which, when the cover (147) is closed, the locking hooks (156) engage the stop shoulders (157) so as to prevent opening, and an unlocking position.

26. A device as claimed in one of claims 1 to 7 or 12 to 25 or forming part of a range as claimed in one of claims 8 to 10, characterized in that the terminal-box (13) has, facing away from the input/output card (7), a row of luminous indicators (54), a row of screws (76) for clamping the wires (89) in the outer terminals (14), and a row of orifices (90) for introducing a wire (89) into an outer terminal (14), these orifices and the screws being oriented so that the wires (89) are inserted there substantially parallel to the card (7), each luminous indicator (54) being adjacent to a terminal (14), the state of which it makes it possible to monitor.

27. A device as claimed in claim 26, characterized in that each luminous indicator comprises a light source (56) mounted on the input/output card (7) and an optical duct (54) extending through the terminal-box (12).

28. A device as claimed in either one of claims 26 or 27, characterized in that each outer terminal (14) possesses a bell-crank like device (93) between the end of the screw (76) and an associated part (96) engaging the wire (89).

1 / 10

FIG.1

FIG.4

FIG_2

FIG_3

3 / 10

FIG.5

FIG.6

FIG.7

FIG.8

FIG_9

FIG. 10

98

## FIG.11

8

98

123

58

129

89

13

132

98

13

58

## FIG.12

98

132

129

FIG_13

FIG.14

FIG.15

FIG.16

## FIG.17

## FIG.18